# EUROPEAN PATENT APPLICATION

(11) **EP 1 143 647 A2**
(43) Date of publication of application: **10.10.2001**
(21) Application number: 00112646.5
(22) Date of filing: 15.06.2000
(51) Int. Cl.: H04H 1/00

(54) **Apparatus for recording a radio broadcast signal in real time and for reproducing the broadcast signal when a user desires to listen to it**

(30) Priority: 23.03.2000 KR 0014895
(71) Applicant: Etostem Co., Ltd., Seoul (KR); Baek, Young-Hyun, Seoul (KR)
(72) Inventor: Beak, Jung-Hyun, Youngdeonpo-ku, Seoul (KR); Kim, Soo-In, Youngdeonpo-ku, Seoul (KR); Baek, Hwa-Youn, Youngdeonpo-ku, Seoul (KR); Jang, Young-Hyun, Youngdeonpo-ku, Seoul (KR)
(74) Representative: Patentanwälte Hauck, Graalfs, Wehnert, Döring, Siemons

(57) **Abstract**

An apparatus for recording and playing radio broadcasting signals in real time includes a tuner for demodulating sound data of a channel when an user selects the channel with a specific frequency among airwave radio broadcasting signals received via an antenna, a sound output section for outputting the demodulated sound data from the tuner to the outside in order to enable the user to listen it, a key input section providing key signals for controlling the apparatus by the operation the user, a central processing section which controls the whole operation of the apparatus in response to the key signals from the key input section, a reference clock generation section providing a reference clock signal necessary for the operation of the central processing section, an analog to digital converter for converting present demodulated analog sound data from the tuner into digital sound data in response to a control signal of said central processing section, a data storing section for storing a certain time period of the digital sound data from the analog-digital converter in real time in response to a control signal from the central processing section, and a digital to analog converter for converting the digital sound data into audible analog sound data in response to a control signal from the central processing section and then transmitting the audible analog sound data to the sound output section.

## Description

### BACKGROUND OF THE INVENTION

### Field of the Invention

The present invention relates to an apparatus for recording and playing radio broadcasting signals and, more particularly, to an improved apparatus for recording and playing radio broadcasting signals that stores a certain time period of information continuously in real time while listening a radio broadcasting and reproduces the stored information when an user desires to listen it.

As it is recently required for the society to get developed as a high-tech information society, rapid obtaining of information continues to one of the important points in the society. In general, Internet information via computers or television broadcasting information is a sort of information transmission system in which information is transmitted in the unit of hour, information of news paper etc. is a sort of information system in which information is transmitted in the unit of day, and radio broadcasting information is sort of information transmission system in which information is transmitted in the unit of second and minute.

Conventional radio receivers for receiving radio broadcasting signals receive and output only sound data transmitted from radio broadcasting stations. The conventional radio receivers are small sizes and thus have a feature to conveniently carry them along. The conventional radio receivers has also a feature in that they transmit the radio broadcasting information rapidly. The conventional radio receivers has a tuner in its inside. The radio receivers thus select a particular frequency using the tuner and receive the selected frequency of radio broadcasting signal to demodulate the received broadcasting signals and moreover output the demodulated sound signal through a speaker.

As above-mentioned, the radio receivers can obtain information rapidly and are still proper for moving type of life styles due to excellent information adaptability. The above-reasons lead the radio receivers to be selected as one of the important information sources in these days of high-technology. The radio broadcasting information is transmitted to listeners in one way of sound information using air waves. Therefore, nevertheless an important information to listeners, it is frequent for the listeners to instantly miss the radio broadcasting information and moreover to lose the value as information. Particularly, the information passes already at the instant that a listener recognizes the information as a valuable one. Therefore, there is a disadvantage in that the listener can not listen the information again even if he or she wants to listen it once more.

### SUMMARY OF THE INVENTION

The present invention has been made in view of the above circumstances has as an object to provide an apparatus for recording and playing radio broadcasting signals in real time and, more particularly, to provide an improved apparatus for recording and playing the radio broadcasting signals that stores a certain time period of information continuously in real time while listening a radio broadcasting and reproduces the stored information when an user desires to listen it.

To achieve the object in accordance with the present invention, as embodied and broadly described herein, the invention comprises a tuner tuning received radio broadcasting signals to select a channel having a specific frequency among the signals and demodulate sound data of the selected channel, a sound output section outputting the demodulated sound data from the tuner to the outside in order to enable an user to listen it, a key input section providing key signals by the user's operation, a central processing section controlling the whole operation of the apparatus in response to the key signals from the key input section, a reference clock generation section providing reference clock signals necessary for the operation of the central processing section, a analog-digital converter converting the analog sound data from the tuner into digital sound data by a control signal from the central processing section, a data storing section storing a certain time period of the digital sound data from the analog-digital converter in accordance with a control signal of the central processing section, and a digital-analog converter converting the stored digital sound data into analog sound data and then transmitting the analog sound data to the sound output section.

According to an additional feature of the present invention, the key input section includes a plurality of buttons and it is preferable for the central processing section to generate each different control signals depending on selected buttons of the key input section.

According to a further additional feature of the present invention, the sound output section includes a sound signal selection section selecting one of the output signals of the tuner and the digital-analog converter. The sound signal selection section outputs the demodulated sound data from the tuner to the outside while the data storing section records the certain time period of the digital sound data, and outputs the sound data outputted from the digital-analog converter to the outside while the data storing section reproduces the sound stored therein.

According to a further additional feature of the present invention, it is preferable for the data storing section to input the inputting sound data in real time and orderly in the a memory, and erase the previously stored sound data in the input order when the capacity of the memory gets over. It is also preferable for the data storing section to store sound data inputting at present in real time and in the input order in a region of the memory the previously stored sound data are erased.

It is to be understood that both the foregoing general description and the following detailed description are exemplary and explanatory only and are not restrictive of the invention, as claim.

### BRIEF DESCRIPTION OF THE DRAWINGS

The accompanying drawings, which are incorporated in and constitute a part of this specification, illustrate embodiments of the invention and together with the description, serve to explain the principles of the invention.

Figure 1 illustrates a block diagram of an apparus in accordance with the present invention.

Figure 2 illustrates a diagram showing buttons mounted to the apparatus and generating different control signals.

### DESCRIPTION OF THE PREFERRED EMBODIMENT

Reference will now be made in detail to the present exemplary embodiment of the invention illustrated in the accompanying drawings. Wherever possible, the same reference numbers will be used throughout the drawings to refer to the same or like parts.

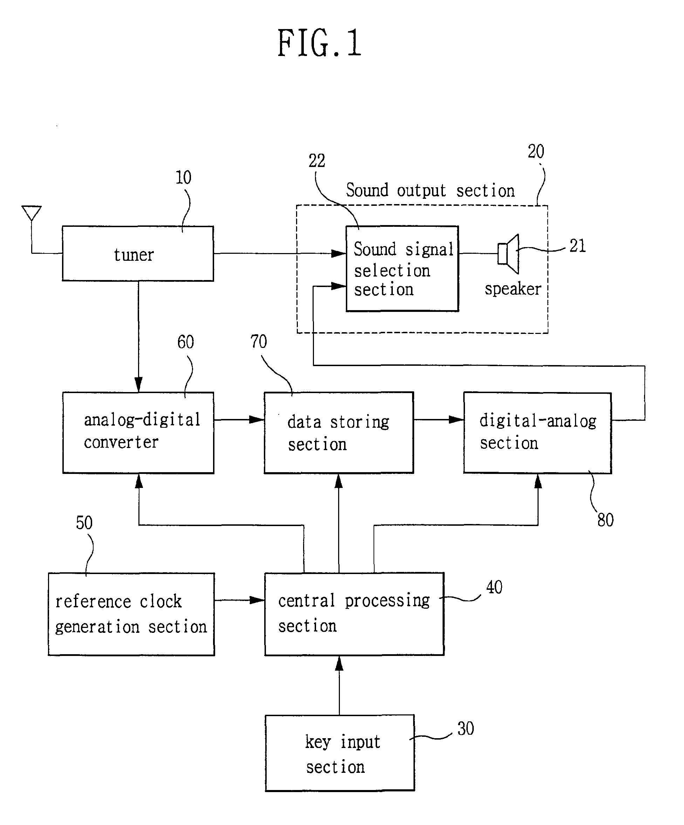

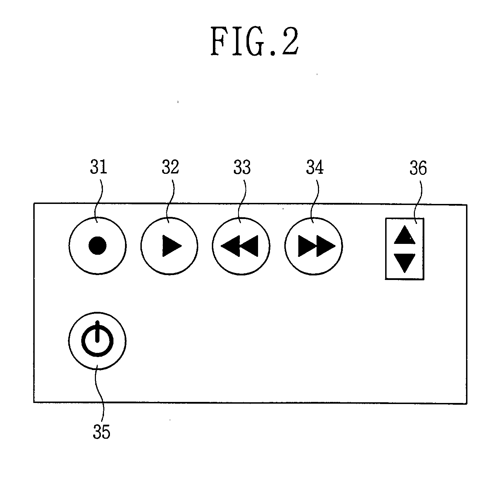

Figure 1 illustrates a block diagram of an apparatus in accordance with the present invention. Figure 2 illustrates a diagram showing buttons mounted to the apparatus and generating different control signals.

Referring to Figure 1, a reference numeral 10 represents a tuner which demodulates sound data of a channel when an user selects the channel with a specific frequency among airwave radio broadcasting signals received via an antenna. A reference numeral 20 represents a sound output section which outputs the sound data by the tuner to the outside in order to enable the user to listen it. It is preferable for the bit-rate per sample of the tuner 10 to be set 8-16 bits/sample in order to ensure at least of dynamic range. A reference numeral 30 represents a key input section providing key signals for controlling the apparatus by the operation the user. A reference numeral 40 represents a central processing section which controls the whole operation of the apparatus in response to the key signals from the key input section 30. A reference numeral 50 represents a reference clock generation section providing a reference clock signal necessary for the operation of the central processing section 40.

As shown in Figure 2, the key input section 30 comprises a recording and broadcasting listening button 31 for operating the apparatus in a normal mode, a reproducing button 32 for reproducing sound data stored in the data storing section 70, a reverse moving button 33 for moving a reproducing location backward by a constant time upon reproducing-operation, a forward moving button 34 for moving a reproducing location forward by a constant time upon reproducing-operation, a power and volume adjustment button 35 for deciding turn on or turn off of the power and deciding the magnitude of the volume, and a channel selection button 36 for selecting a channel among radio broadcasting channels.

The central processing section 40 may be a low cost of one chip processor and the reference clock generation section 40 provides clocks over 32KHz as the reference clock signal. A reference numeral 60 represents a analog to digital converter for converting present analog sound data demodulated at the tuner 10 into digital sound data in response to a control signal of the central processing section 40. A reference numeral 70 represents a data storing section for storing a certain time period of the digital sound data outputted from the analog-digital converter 60 in real time in accordance with a control signal from the central processing section 40. A reference numeral 80 represents a digital to analog converter for converting the digital sound data into aural analog sound data in accordance with a control signal from the central processing section 40 and then transmitting the aural analog sound data to the sound output section 20.

The analog-digital converter 60 has a sampling frequency of 12-24KHz in order to support a sound band of 6-12KHz. It is also preferable for the data storing section 70 to be a dynamic random access memory (DRAM) with a capacity of 1-8Mbyte in order to store the digital sound data for 3-5 minutes. It is also preferable for the bit rate per sample of the digital to analog converter 80 to be 8-16 bits/sample and for the sampling frequency of the digital to analog converter 80 to be 12-24KHz in order to support a sound band of 6-12 KHz.

The sound output section 20 comprises a speaker 21 and a sound signal selection section 22. The sound signal selection section 22 outputs the demodulated sound data from the tuner 10 to the outside while the data storing section 70 records the certain time period of the digital sound data converted by the analog to digital converter 60, and outputs the sound data outputted from the digital-analog converter 80 to the outside via the speaker 21 while the sound data stored in the data storing section 70 are reproduced. The data storing section 70 stores inputting sound data in real time and orderly in a memory, and erase previously stored sound data in the input order when the capacity of the memory gets over. The data storing section 70 also stores present inputting sound data in real time and in the input order in a region of the memory the previously stored sound data are erased.

The operation of the apparatus in accordance with the present invention will be hereinafter described in detail. When the operation of the apparatus starts, a mode for normal radio listening is set up and a specific channel of radio broadcasting among airwave radio broadcasting signals received via an antenna is tuned by the tuner 10. Accordingly, a sound data are outputted through the sound output section 20, thereby enabling the user to listen it. At this time, if the user selects the button 31 for recording and broadcasting listening of the key input section 30, present analog sound data demodulated at the tuner 10 are converted into digital data by the analog to digital converter 60 and the digital sound data is then stored in real time in the data storing section 70 which can store contents of radio broadcasting for 3-5 minutes.

During the above-operation, the data storing section 70 erases the previously stored sound data in the inputted order when the capacity of the memory gets over. The data storing section 70 stores sound data inputting at present in real time and in the inputted order in a region of the memory that the previously stored sound data are erased..The above storing function continues until the mode changes to a reproducing mode and just previous sound data with a certain amount are kept using a reproducing time point as a reference. At this time, it is preferable to use mono audio recording when compared the cost of the data storing section 70. After that, if the user selects the reproducing button 32 of the key input section 30, the storing function is stopped and the digital sound data stored in the data storing section 70 are converted into audible analog sound data by the digital to analog converter 80. The audible analog sound data are transmitted to the data output section 20 so that the user can listen the sound. At this time, if the user selects the reverse moving button 33 or the forward moving button 34, the reproducing position moves forward or backward by a constant time. The moving speed may be varied to a double speed, a three times speed, and a four times speed besides of a basic reproducing mode i.e. one time speed through an additional function. If the user selects the button 31 for recording and broadcasting listening of the key input section 30 after the user listen a desired information, the mode moves to the recording mode again and present demodulated sound data are stored.

It will be apparent to those skilled in the art that various modifications and variations can be made without departing from the scope or spirit of the invention. Other embodiments of the invention will be apparent to those skilled in the art from the consideration of the specification and practice of the invention disclosed herein. For example, the technical concept of the present invention is not limited to the application to the radio receivers and may be applied to the mobile communication field such as cellular phones or the fixed communication field such as television broadcastings. In other words, a conversation content can be all stored during conversation via a cellular phone and the stored content thereafter may be reproduced by the user's selection. During watching the television receiver, the user may store any outputted data via the television receiver consecutively in real time by a certain time period and the stored data may then be reproduced by the user's selection.

As above-mentioned, the apparatus in accordance with the present invention has an advantage that when listeners instantly miss necessary information during listening a radio broadcasting they can listen the information again.

## Claims

1. an apparatus for recording and playing radio broadcasting signals in real time, comprising:
a tuner for demodulating sound data of a channel when an user selects said channel with a specific frequency among airwave radio broadcasting signals received via an antenna;
a sound output section for outputting said demodulated sound data from said tuner to the outside in order to enable said user to listen it;
a key input section providing key signals for controlling said apparatus by said operation said user;
a central processing section which controls the whole operation of said apparatus in response to said key signals from said key input section;
a reference clock generation section providing a reference clock signal necessary for said operation of said central processing section;
an analog to digital converter for converting present demodulated analog sound data from said tuner into digital sound data in response to a control signal of said central processing section;
a data storing section for storing a certain time period of said digital sound data from said analog-digital converter in real time in response to a control signal from said central processing section; and
a digital to analog converter for converting said digital sound data into audible analog sound data in response to a control signal from said central processing section and then transmitting said audible analog sound data to said sound output section.

2. an apparatus for recording and playing radio broadcasting signals in real time according to claim 1, wherein said key input section includes a plurality of buttons and said central processing section generates each different control signals depending on a selected one of said plurality of buttons.

3. an apparatus for recording and playing radio broadcasting signals in real time according to claim 1, wherein said sound output section comprises a sound signal selection section for outputting said demodulated sound data from said tuner to the outside while said data storing section records said digital sound data converted by said analog to digital converter and outputting said sound data outputted from said digital-analog converter to the outside via a speaker while said sound data stored in said data storing section is reproduced.

4. an apparatus for recording and playing radio broadcasting signals in real time according to claim 1, wherein said data storing section stores inputting sound data in real time and orderly in a memory, erase previously stored sound data in the input order when the capacity of said memory gets over, and stores present inputting sound data in real time in the input order in a region of said memory in which said previously stored sound data is erased.
